Europäisches Patentamt

European Patent Office

Office européen des brevets

(11) Veröffentlichungsnummer: **0 346 682**
**A1**

## (12) EUROPÄISCHE PATENTANMELDUNG

(21) Anmeldenummer: **89109801.4**

(51) Int. Cl.⁴: **H03L 7/00**

(22) Anmeldetag: **31.05.89**

(30) Priorität: **11.06.88 DE 3819930**

(43) Veröffentlichungstag der Anmeldung:
**20.12.89 Patentblatt 89/51**

(84) Benannte Vertragsstaaten:
**AT BE CH DE ES FR GB GR IT LI LU NL SE**

(71) Anmelder: **Deutsche Thomson-Brandt GmbH**
**Hermann-Schwer-Strasse 3 Postfach 1307**
**D-7730 Villingen-Schwenningen(DE)**

(72) Erfinder: **Pery, Antoine**
**Mannheimer Strasse 17**
**D-7730 Villingen-Schwenningen(DE)**

(54) **Schaltungsanordnung zur Einstellung der Phasenlage eines Signals.**

(57) Bei der Verwendung einer mit Toleranz behafteten Glasverzögerungsleitung (1) ist ein Abgleich notwendig, um ein genauen Phasenunterschied von z.B. 180° einzustellen. Es ist bekannt, dazu an den Eingang und/oder Ausgang LC-Kreise anzuschalten, die individuell abgeglichen werden müssen.

Die Erfindung vermeidet den damit verbundenen Kostenaufwand, indem der Phasenabgleich automatisch erfolgt. An den Ausgang der Verzögerungsleitung ist ein steuerbarer Phasenschieber (3) geschaltet. Die Steuerspannung hierfür wird dadurch erzeugt, daß an den einen Eingang einer Multiplizierstufe (5) das Ausgangssignal des steuerbaren Phasenschiebers und an den anderen Eingang eine exakt um 90° gedrehte Komponente des der Verzögerungsleitung zugeführten Eingangssignals gelegt wird. Der Abgleich erfolgt solange, bis sich eine am Ausgang der Multiplizierstufe erzeugte Spannung nicht mehr ändert, die dem Steuereingang Phasenschiebers zugeführt wird.

Automatische Phaseneinstellung bei Kammfiltern oder Farbdecodern in Farbfernsehempfängern.

## Schaltungsanordnung zur Einstellung der Phasenlage eines Signals

Die Erfindung betrifft eine Schaltungsanordnung zur Einstellung der Phasenlage eines durch ein phasendrehendes Glied erzeugten Ausgangssignals in Bezug auf ein diesem zugeführtes Eingangssignal.

Bei der elektronischen Signalverarbeitung kommt es immer wieder vor, daß Signale zeitlich verzögert werden müssen. Dazu werden diese an eine Verzögerungsleitung gelegt, an deren Ausgang das verzögerte, d.h. phasengedrehte Signal abnehmbar ist. Dabei kommt es oftmals auf die Einhaltung genauer Phasenbeziehungen an, so daß z.B. die Forderung besteht, ein gegenüber dem Eingangssignal genau um 180° phasengedrehtes Ausgangssignal zu erzeugen. Die Verzögerungsleitung besitzt jedoch wie alle elektronischen Bauelemente Toleranzen, so daß sich eine Phasendrehung mit einer Abweichung von etwa +/- 6° ergibt. Dies ist z.B. der Fall bei einer Glasverzögerungsleitung in einem Kammfilter oder in einem Farbdecoder eines Farbfernsehempfängers. Es ist daher unbedingt notwendig, diese Phasenabweichungen zu korrigieren. Das geschieht mit Hilfe eines am Eingang und/oder am Ausgang der Verzögerungsleitung angeordneten abgleichbaren LC-Kreises, mit dem man die richtige Phasenbeziehung zwischen Eingangssignal und Ausgangssignal herstellen kann. Ausser den teuren Bauteilen ist noch der manuelle Abgleichaufwand zu berücksichtigen.

Der Erfindung liegt die Aufgabe zugrunde, diesen Aufwand zu reduzieren und insbesondere den Abgleichvorgang zu automatisieren, so daß die Toleranzen ständig ausgeglichen werden und ein Nachabgleich nicht mehr notwendig wird. Diese Aufgabe wird durch die im Patentanspruch angegebene Maßnahme gelöst.

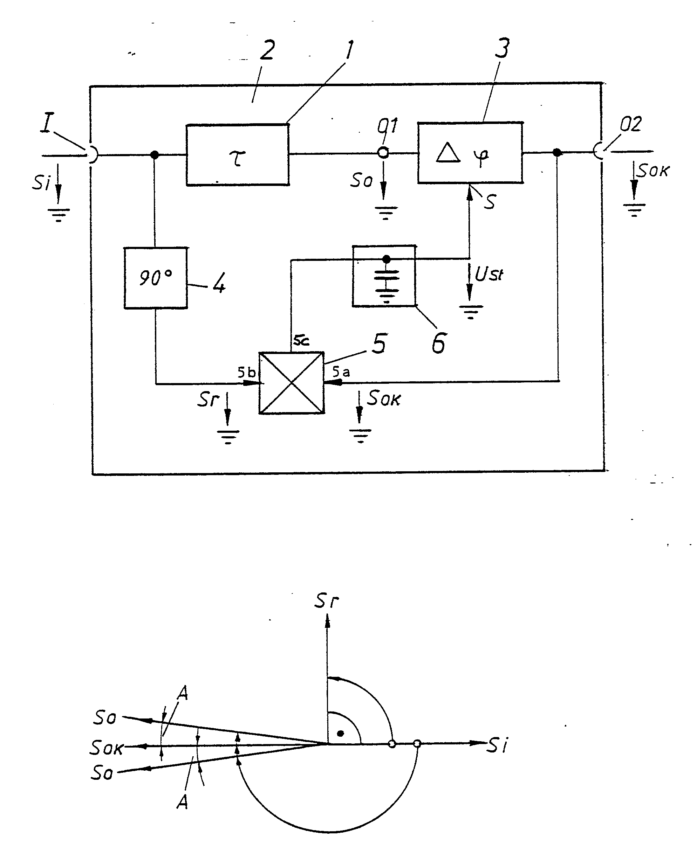

Nachstehend wird die Erfindung mit Hilfe der Zeichnung erläutert.

Ein an den Eingang I eines phasendrehenden Gliedes, z.B. in Form einer Verzögerungsleitung 1 angelegtes Eingangssignal Si soll am Ausgang 02 der noch näher zu beschreibenden Schaltungsanordnung 2 als exakt um 180° gedrehtes Ausgangssignal Sok erscheinen. Am Ausgang 01 der Verzögerungsleitung 1 liegt das noch in der Phase abweichende Ausgangssignal mit einer Winkelfehlertoleranz von +/- A°. Zum Ausgleich dieses Fehlers ist an den Ausgang 01 der Verzögerungsleitung 1 ein Phasenschieber 3 geschaltet, welcher mit Hilfe einer an einen Steuereingang S angelegten Steuerspannung Ust auf das diesem zugeführte Signal eine phasendrehende Wirkung ausübt. Die dazu benötigte Steuerspannung Ust wird folgendermaßen erzeugt. Zunächst wird ein zum Eingangssignal Si exakt um 90° verschobenes Referenzsignal Sr erzeugt. Das kann z.B. mit Hilfe eines Phasendrehgliedes 4 oder auch mit Hilfe einer in PLL-Technik aufgebauten Oszillatorschaltung erfolgen. Dieses Referenzsignal Sr wird an einen ersten Eingang 5b einer Multiplizierstufe 5 gegeben. Dem zweiten Eingang 5a dieser Multiplizierstufe 5 wird das Ausgangssignal Sok der Schaltungsanordnung 2 zugeführt. Nun besitzt die Multiplizierstufe 5 bekanntlich die Eigenschaft, daß an deren Ausgang nur dann eine Schwingung mit dem Mittelwert Null erscheint, wenn beide Eingangsspannungen genau um 90° in ihrer Phasenlage verschoben sind. Sobald dieser Phasenunterschied größer oder kleiner ist, ergibt sich am Ausgang ein Signal, dessen Mittelwert von Null verschieden ist. Dieser Wert wird in einem Filter 6 gespeichert und verstellt als Steuerspannung Ust den Phasenschieber 3 solange, bis der Wert am Steuereingang konstant bleibt. Das ist dann der Fall, wenn die Signale Sr und Sok genau um 90° verschoben sind. Das bedeutet aber auch, daß dann die Ausgangsignale Sok und das Eingangssignal Si genau um 180° verschoben sind.

## Ansprüche

1. Schaltungsanordnung zur Einstellung der Phasenlage eines durch ein phasendrehendes Glied erzeugtes Ausgangssignals in Bezug auf ein diesem zugeführtes Eingangssignal, **dadurch gekennzeichnet,** daß an den Ausgang (01) des phasendrehenden Gliedes (1) ein steuerbarer Phasenschieber (3) angeschaltet ist, an welchem das Ausgangssignal $S_{ok}$ abnehmbar ist, welches an den einen Eingang (5a) einer Multiplizierschaltung (5) gelegt ist, deren anderem Eingang (5b) ein gegenüber dem Eingangssignal $S_i$ um 90° gedrehtes Signal $S_r$ zugeführt ist, und daß der Ausgang (5c) der Multiplizierschaltung (5) über ein Filter (6) an den Steuereingang (S) des Phasenschiebers (3) geschaltet ist.

2. Schaltungsanordnung nach Anspruch 1, **dadurch gekennzeichnet,** daß das phasendrehende Glied (1) eine Verzögerungsleitung ist.

3. Schaltungsanordnung nach Anspruch 1 oder 2, **dadurch gekennzeichnet,** daß die Verzögerungsleitung in einem Farbfernsehempfänger angeordnet ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 335 048 (CINCINNATI MILACRON)<br>* Seite 4, Zeilen 9-24; Figur 2 *<br>--- | 1-3 | H 03 L 7/00 |
| X | ELECTRONICS LETTERS, Band 20, Nr. 10, 10. Mai 1984, Seiten 431-432, London, GB; E.W. TAY et al.: "Unity-gain frequency-independent quadrature phase shifter"<br>* Insgesamt *<br>--- | 1-3 | |
| A | GB-A-1 515 408 (MATSUSHITA)<br>* Seite 1, Zeile 15 - Seite 2, Zeile 11; Figuren 1,11,12 *<br>--- | 1-3 | |
| A | IEE PROCEEDINGS SECTION A-I, Nr. 4, Juni 1984, Teil A, Seiten 216-224, Old Woking, Surrey, GB; P. DEFRANOULD: "Bulk acoustic microwave delay lines: design, fabrication and performance"<br>* Seite 216, linke Spalte, Zeile 11 *<br>--- | 3 | |
| A | US-A-4 573 027 (BUCHALTER et al.)<br>* Spalte 2, Zeile 55 - Spalte 3, Zeile 12; Figur 1 *<br>--- | 1,2 | **RECHERCHIERTE SACHGEBIETE (Int. Cl.4)**<br><br>H 03 L<br>G 01 R |
| A | US-A-3 836 864 (JEZO)<br>* Figur 1 *<br>----- | 1 | H 03 B<br>H 03 H |

Der vorliegende Recherchenbericht wurde für alle Patentansprüche erstellt

| Recherchenort | Abschlußdatum der Recherche | Prüfer |
|---|---|---|
| DEN HAAG | 15-09-1989 | DHONDT I.E.E. |